# EUROPEAN PATENT APPLICATION

(11) **EP 4 733 777 A1**
(43) Date of publication of application: **29.04.2026**
(21) Application number: 25210563.0
(22) Date of filing: 22.10.2025
(51) Int. Cl.: G01R 15/18, G01R 15/20, G01R 31/08, G01R 31/52, H02G 9/02

(54) **SYSTEM AND METHOD FOR DETERMINING THE CONDITION OF A SUBSEA CIRCUIT**

(30) Priority: 23.10.2024 GB 202415589
(71) Applicant: Siemens Energy AS, 0596 Oslo (NO)
(72) Inventor: Kristiansen, Karstein Berge, 7051 Trondheim (NO)
(74) Representative: Isarpatent

(57) **Abstract**

A subsea communication system includes a subsea cable positioned subsea and exposed to water at a subsea pressure and a subsea temperature. A plurality of wires is disposed within the subsea cable, with each wire of the plurality of wires including an insulation layer arranged to inhibit current leakage in response to contact with the water. The system further includes a plurality of non-intrusive current sensors, with each non-intrusive current sensor positioned subsea, coupled to a pair of the wires of the plurality of wires and operable to measure a measured current in the associated pair of wires without affecting the current in the pair of wires. A controller is operable to receive the measured current from each non-intrusive current sensor of the plurality of non-intrusive current sensors and compare the measured current to an expected current to determine an insulating condition of a circuit partially defined by the pair of wires of the plurality of wires.

## Description

### BACKGROUND

Communication systems are employed in subsea environments to communicate between topside equipment and subsea equipment or to communicate between pieces of equipment that are both located subsea. Communication can include the transfer of power, control signals, fiber optics, and the like.

Repairing or replacing damaged communication circuits can be very costly in the subsea environment. In addition, operation of the communication circuits can be challenging due to the subsea environment. It is therefore desirable to be able to plan for maintenance and repair at times and places that are convenient to reduce the costs and difficulties.

### SUMMARY

In one aspect, a subsea communication system includes a subsea cable positioned subsea and exposed to water at a subsea pressure and a subsea temperature. A plurality of wires is disposed within the subsea cable, with each wire of the plurality of wires including an insulation layer arranged to inhibit current leakage in response to contact with the water. The system further includes a plurality of non-intrusive current sensors, with each non-intrusive current sensor positioned subsea, coupled to a pair of the wires of the plurality of wires and operable to measure a measured current in the associated pair of wires without affecting the current in the pair of wires. A controller is operable to receive the measured current from each non-intrusive current sensor of the plurality of non-intrusive current sensors and compare the measured current to an expected current to determine an insulating condition of a circuit partially defined by the pair of wires of the plurality of wires.

The subsea communication system may also include an arrangement in which the measured current is a difference between a first current in a first wire of the pair of wires and a second current in the second wire of the pair of wires, and where the expected current is zero.

The subsea communication system may also include an arrangement in which a non-zero measured difference is directly indicative of a current leak in one of the wires of the pair of wires.

The subsea communication system may operate at a subsea pressure between 10 bars and 200 bars.

The subsea communication system may also include a non-intrusive current sensor in the form of a Hall sensor.

The subsea communication system may also include a non-intrusive sensor having a coil that surrounds a portion of the wires to which the non-intrusive current sensor is coupled.

The subsea communication system may also include an allowable current loss for each wire stored in the controller, and where the controller compares the difference between the measured current and the expected current for each wire to the allowable current loss for the associated wire to predict a time to failure for each wire.

The subsea communication system may also include a controller in the form of one of a computer and a programmable logic controller.

The subsea communication system may also include a plurality of switches, each switch of the plurality of switches coupled to one of the wires of the plurality of wires.

The subsea communication system may also include a controller that is operable to open each switch in response to the difference between the measured current and the expected current exceeding an allowable current loss for the associated wire.

In another aspect, a method of monitoring insulation damage in each wire of a plurality of wires disposed subsea and exposed to water at a subsea pressure includes positioning a plurality of non-intrusive current sensors subsea, each non-intrusive current sensor of the plurality of non-intrusive current sensors coupled to one of a pair of the wires of the plurality of wires. The method further includes operating each non-intrusive current sensor of the plurality of non-intrusive current sensors to measure a measured current for each one of the pairs of wires of the plurality of wires without manipulating the current in the pair of the wires, and comparing the measured current to an expected current for each pair of wires of the plurality of wires to determine an insulating condition of a circuit partially defined by the pair of wires of the plurality of wires.

The method may also include a process in which the measured current is a difference between a first current in a first wire of the pair of wires and a second current in the second wire of the pair of wires, and where the expected current is zero.

The method may also include directly indicating a current leak in the pair of wires without the manipulation of any data in response to a non-zero measured current.

The method may also include operating at a subsea pressure between 10 bars and 200 bars.

The method may also include using a non-intrusive current sensor in the form of a Hall sensor.

The method may also include positioning a coil of each non-intrusive current sensor to surround a portion of the wire to which the non-intrusive current sensor is coupled.

The method may also include comparing the difference between the measured current and the expected current for each wire to an allowable current loss for the associated wire to predict a time to failure for each wire.

The method may also include positioning a plurality of switches with each switch of the plurality of switches coupled to one of the wires of the plurality of wires.

The method may also include opening the switch associated with a wire in response to the difference between the measured current and the expected current exceeding an allowable current loss for the associated wire.

Other technical features may be readily apparent to one skilled in the art from the following figures, descriptions, and claims.

### BRIEF DESCRIPTION OF THE DRAWINGS

To easily identify the discussion of any particular element or act, the most significant digit or digits in a reference number refer to the figure number in which that element is first introduced.
FIG. 1 schematically illustrates a subsea communication system.
FIG. 2 is a section view of a wire suitable for use in the subsea communication system of FIG. 1.
FIG. 3 is a section view of the wire of FIG. 2 illustrating damage to an insulation layer.
FIG. 4 schematically illustrates a portion of one communication circuit of the subsea communication system of FIG. 1.

### DETAILED DESCRIPTION

Before any embodiments of the invention are explained in detail, it is to be understood that the invention is not limited in its application to the details of construction and the arrangement of components set forth in this description or illustrated in the following drawings. The invention is capable of other embodiments and of being practiced or of being carried out in various ways. Also, it is to be understood that the phraseology and terminology used herein is for the purpose of description and should not be regarded as limiting.

Various technologies that pertain to systems and methods will now be described with reference to the drawings, where like reference numerals represent like elements throughout. The drawings discussed below, and the various embodiments used to describe the principles of the present disclosure in this patent document are by way of illustration only and should not be construed in any way to limit the scope of the disclosure. Those skilled in the art will understand that the principles of the present disclosure may be implemented in any suitably arranged apparatus. It is to be understood that functionality that is described as being carried out by certain system elements may be performed by multiple elements. Similarly, for instance, an element may be configured to perform functionality that is described as being carried out by multiple elements. The numerous innovative teachings of the present application will be described with reference to exemplary non-limiting embodiments.

It should be understood that the words or phrases used herein should be construed broadly, unless expressly limited in some examples. For example, the terms "including," "having," and "comprising," as well as derivatives thereof, mean inclusion without limitation. The singular forms "a", "an" and "the" are intended to include the plural forms as well, unless the context clearly indicates otherwise. Further, the term "and/or" as used herein refers to and encompasses any and all possible combinations of one or more of the associated listed items. The term "or" is inclusive, meaning and/or, unless the context clearly indicates otherwise. The phrases "associated with" and "associated therewith," as well as derivatives thereof, may mean to include, be included within, interconnect with, contain, be contained within, connect to or with, couple to or with, be communicable with, cooperate with, interleave, juxtapose, be proximate to, be bound to or with, have, have a property of, or the like. Furthermore, while multiple embodiments or constructions may be described herein, any features, methods, steps, components, etc. described with regard to one embodiment are equally applicable to other embodiments, absent a specific statement to the contrary.

Also, terms such as "first", "second", "third" and so forth may be used herein to refer to various elements, information, functions, or acts, but should not be considered as limiting in any way. Rather these numeral adjectives are used to distinguish different elements, information, functions or acts from each other. For example, a first element, information, function, or act could be termed a second element, information, function, or act, and, similarly, a second element, information, function, or act could be termed a first element, information, function, or act, without departing from the scope of the present disclosure.

In addition, the term "adjacent to" may mean that an element is relatively near to but not in contact with a further element or that the element is in contact with the further portion unless the context clearly indicates otherwise. Further, the phrase "based on" is intended to mean "based, at least in part, on" unless explicitly stated otherwise. Terms "about" or "substantially" or like terms are intended to cover variations in a value that are within normal industry manufacturing tolerances for that dimension. If no industry standard is available, a variation of twenty percent would fall within the meaning of these terms unless otherwise stated.

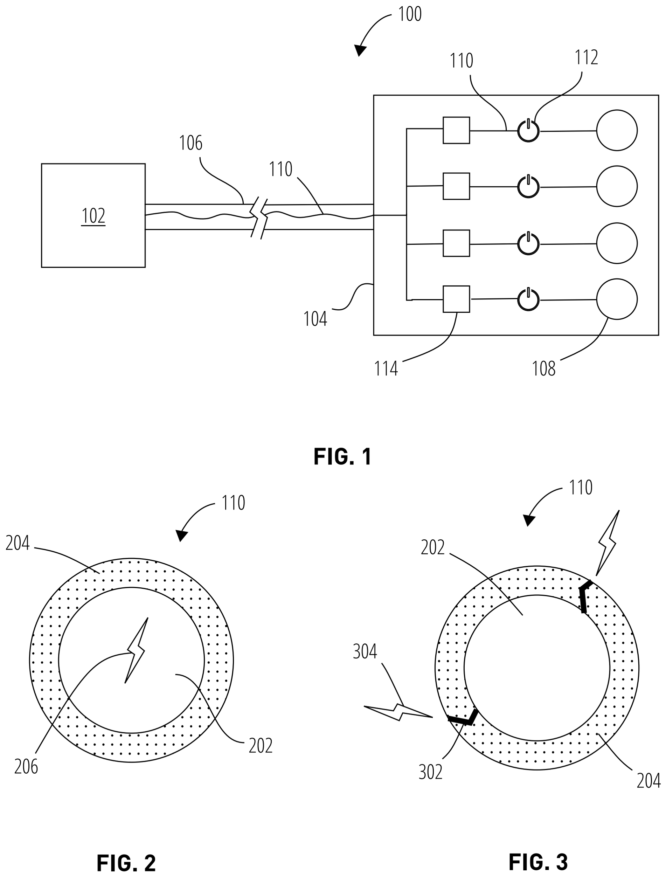

FIG. 1 schematically illustrates a communication system and more specifically a subsea communication system 100 that includes a communication hub 102 connected to a subsea device 104 via a subsea cable 106. The communication hub 102 includes any device or component that is arranged to communicate with another device or component. The communication hub 102 may be located subsea or could be topside such as on a ship, platform or landmass.

The subsea device 104 includes any device, component, machine, assembly or arrangement that requires communication with devices outside of the subsea device 104. Examples include subsea Christmas trees, controllers, transformers, pumps, sensors, and the like. The subsea device 104 includes one or more communication nodes 108 that communicate with the communication hub 102. Each communication hub 102 may be part of a sensor, a pump, a valve, an actuator, a camera, and the like. Each of these devices uses communication to operate and as such may send and/or receive data periodically. It should be noted that "communication" as used herein is intended to broadly include the transfer of power as well as electrical, or other electromagnetic control or sensor signals.

The subsea cable 106 is a cable that includes a quantity of wires 110 as necessary to communicate with each of the communication nodes 108. Additional wires 110 could be provided to allow for communication with additional communication nodes 108 of the subsea device 104 or with communication nodes 108 associated with another subsea device 104.

Each of the wires 110 forms a portion of a communication circuit between the communication hub 102 and a particular communication node 108. The communication circuit may also include a current sensor 112 and a switch 114 that is operable to open or close the particular communication circuit to which it is attached.

The term "subsea" as used herein refers to components that are submerged in water and generally sea water such that they are exposed to cold temperatures (near zero Celsius) and high pressures (e.g., between 10 and 200 Bar). In these operating conditions, cables, wires, and components are susceptible to damage. In addition, repairing or replacing the components can be expensive and time-consuming; particularly if they are unplanned.

FIG. 2 illustrates a section view of a typical wire 110 which includes a conductor 202 surrounded by one or more layers of insulation 204. The conductor could include a single solid conductor, multiple individual conductors, braided or stranded wires, fiber optics, or any other component that conducts electrical power or other signals 206 (electrical or otherwise) along the length of the wire 110.

The insulation 204 may include a single layer or multiple layers of material that protect the conductor 202 and inhibit unwanted short circuits, power or leakage of the signal 206, or interference with the power or signal 206 being conducted. In some constructions, a first layer of insulation may shield the conductor from outside interference with a second layer surrounding the first to inhibit short circuits or damage to the conductor 202 or conductors 202. Additional protection may be provided by placing the wires 110 inside the subsea cable 106 as illustrated in FIG. 1.

FIG. 3 illustrates the wire 110 of FIG. 2 with some damage 302 to the insulation 204. The damage 302 may allow for the entry of water which may increase the pace of the damage 302 or may lead to a leakage current 304 which weakens or reduces the strength of the signal 206.

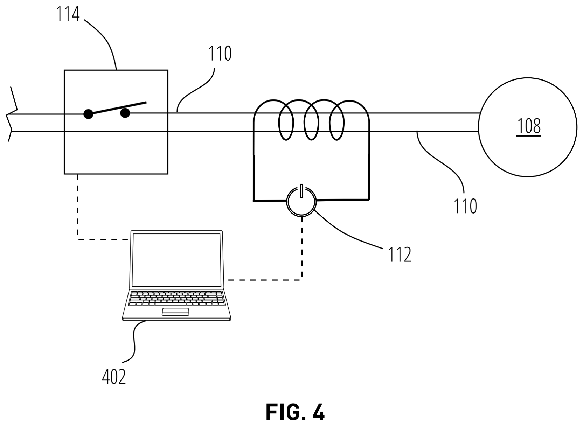

FIG. 4 better illustrates a portion of one of the communication circuits of FIG. 1 and includes a controller 402 that is operable to receive data from the current sensor 112 and to send and/or receive data to/from the switch 114.

As discussed with regard to FIG. 1, the communication circuit includes the wire 110 connected to the communication node 108. The switch 114 is positioned in the communication circuit and is operable to open or close the circuit. As one of ordinary skill will understand virtually any switch arrangement can be employed so long as it can be remotely actuated and controlled.

In the illustrated construction, the current sensor 112 measures the current in the pair of wires 110 and transmits the value of a measured current to the controller 402. Specifically, the current sensor 112 includes a coil that surrounds both wires of the pair and measures the potential difference in the current in a first wire of the pair, compared with the current in the second wire of the pair. If there is a leakage between the wires in the pair, a difference in the two currents will be detected. More specifically, the current in each wire should be equal in magnitude but opposite in direction or polarity such that under ideal conditions, the measured current in the two wires of the pair of wires is zero. The controller 402 uses the value of the measured current, or difference to assess the condition of the communication circuit and in particular the wire 110 and opens the switch 114 if the measured current or the difference differs from an expected value, or zero in the case of a difference by more than a predetermined amount. Because the two wires are measured together, no math or manipulation of the acquired data is needed to determine if there is a current leak. Rather, if the value is not zero, there is a leak and the magnitude of the leak is proportional to the magnitude of the difference between the two wires (i.e., the measured current). The controller 402 may include a computer, a programable logic controller or any other device capable of receiving data, comparing that data to an expected value, and taking action in response to the comparison. These actions may include opening the switch 114 or alerting a user of the condition of the circuit.

It should also be noted that the controller could be located subsea or elsewhere. In addition, a single controller 402 could be employed for multiple circuits or each individual circuit may include its own controller 402.

The current sensor 112 is a non-invasive current sensor that is capable of measuring the current in the wire 110 without having to break the wire. While many different current sensors 112 are possible some examples include split-core current transformers, Hall effect sensors, Rogowski coils, magneto resistive sensors, or fiber optic current sensors.

Split-core current transformers consist of a magnetic core that can be opened and closed around a conductor. When current flows through the conductor, it induces a proportional current in the secondary winding of the transformer. Hall effect sensors use a semiconductor device that produces a voltage proportional to the magnetic field generated by the current-carrying wire 110. The sensor is placed near the conductor without direct contact. Rogowski coils include an air-core toroidal coil placed around the wire 110. It measures the rate of change of current and requires integration to determine the actual current in the wire 110. Magneto resistive sensors are similar to Hall effect sensors. However, magneto resistive sensors change electrical resistance in response to an external magnetic field produced by the current-carrying wire 110. Fiber optic current sensors use the Faraday effect in optical fibers to measure current. The magnetic field from the current in the wire 110 causes a rotation in the polarization of light passing through the fiber.

Of course, many other types of current sensors may be employed as the current sensor 112 so long as those sensors can be used without breaking the wire 110 or interfering with the signal 206 in the wire 110. In other words, the sensor is non-invasive. In addition, the selected type of sensor should be capable of operation in the subsea environment. Specifically, the current sensor 112 should operate properly and provide accurate measurements at very low temperatures (e.g., between -10 and 10 degrees Celsius), at high pressures (e.g., between 10 and 200 Bar), while submerged in water, and preferably sea water.

In operation, the communication hub 102 is connected to the subsea device 104 via one or more subsea cables 106. The subsea device 104 includes one or more communication nodes 108 which benefit from communication between the communication hub 102 and the individual communication nodes 108. Thus, each communication node 108 is part of an individual circuit that facilitates the desired communication between the communication hub 102 and the communication node 108.

The switch 114 and the current sensor 112 is positioned in each of the circuits in the subsea environment. The current sensor 112 is positioned and selected to non-invasively measure the current or the level of the signal 206 flowing through the wire 110. The value of the measured current is transmitted to the controller 402 which may be subsea or may be positioned elsewhere. The controller 402 compares the measured current to an expected value to determine if the measured current has deviated from the expected current by more than a predetermined amount (i.e., an allowable current loss). If the measured current has deviated more than the predetermined amount, the controller 402 operates to open the switch 114 and/or to alert a user that the circuit may be damaged. Additionally, the controller 402 can track the measured current over time and from that data determine if the circuit is deteriorating and possibly predict when a failure may occur. This would allow for replacement or repair at times or places that may be more convenient, and therefore less expensive.

The arrangement illustrated herein allows for the direct non-invasive measurement of a current between two wires in a circuit. The measured current under ideal condition should be zero with any non-zero value being indicative of a current leak and possible a fault in the insulation. Furthermore, the measured current is proportional to the magnitude of the leakage and can be readily determined with little to no calculations or manipulation of the collected data. In addition, the arrangement illustrate herein does not require any test signals, fixed voltages, or baseline measurements to operate. It operates continuously if desired and is fully non-invasive in that no changes to the signals carried by the wires or input signals of any type are required.

Although an exemplary embodiment of the present disclosure has been described in detail, those skilled in the art will understand that various changes, substitutions, variations, and improvements disclosed herein may be made without departing from the spirit and scope of the disclosure in its broadest form.

None of the descriptions in the present application should be read as implying that any particular element, step, act, or function is an essential element, which must be included in the claim scope: the scope of patented subject matter is defined only by the allowed claims. Moreover, none of these claims are intended to invoke a means plus function claim construction unless the exact words "means for" are followed by a participle.

## Claims

1. A subsea communication system comprising:
a subsea cable positioned subsea and exposed to water at a subsea pressure and a subsea temperature;
a plurality of wires disposed within the subsea cable, each wire of the plurality of wires including an insulation layer arranged to inhibit current leakage in response to contact with the water;
a plurality of non-intrusive current sensors, each non-intrusive current sensor positioned subsea, coupled to a pair of the wires of the plurality of wires and operable to measure a measured current in the associated pair of wires without affecting the current in the pair of wires; and
a controller operable to receive the measured current from each non-intrusive current sensor of the plurality of non-intrusive current sensors and compare the measured current to an expected current to determine an insulating condition of a circuit partially defined by the pair of wires of the plurality of wires.

2. The subsea communication system of claim 1, wherein the measured current is a difference between a first current in a first wire of the pair of wires and a second current in the second wire of the pair of wires, and wherein the expected current is zero.

3. The subsea communication system of claim 2, wherein a non-zero measured difference is directly indicative of a current leak in one of the wires of the pair of wires.

4. The subsea communication system according to any of the preceding claims, wherein the subsea pressure is between 10 bars and 200 bars.

5. The subsea communication system according to any of the preceding claims, wherein each non-intrusive current sensor includes a Hall sensor.

6. The subsea communication system according to any of the preceding claims, wherein each non-intrusive sensor includes a coil that surrounds a portion of the wire to which the non-intrusive current sensor is coupled.

7. The subsea communication system according to any of the preceding claims, further comprising an allowable current loss for each wire stored in the controller, and wherein the controller compares the difference between the measured current and the expected current for each wire to the allowable current loss for the associated wire to predict a time to failure for each wire.

8. The subsea communication system according to any of the preceding claims, wherein the controller includes one of a computer and a programmable logic controller.

9. The subsea communication system according to any of the preceding claims, further comprising a plurality of switches, each switch of the plurality of switches coupled to one of the wires of the plurality of wires, wherein the controller is in particular operable to open each switch in response to the difference between the measured current and the expected current exceeding an allowable current loss for the associated wire.

10. A method of monitoring insulation damage in each wire of a plurality of wires disposed subsea and exposed to water at a subsea pressure, in particular by employing a subsea communication system according to any of the claims 1 to 9, the method comprising:
positioning a plurality of non-intrusive current sensors subsea, each non-intrusive current sensor of the plurality of non-intrusive current sensors coupled to one of a pair of the wires of the plurality of wires;
operating each non-intrusive current sensor of the plurality of non-intrusive current sensors to measure a measured current for each one of the pairs of wires of the plurality of wires without manipulating the current in the pair of the wires; and
comparing the measured current to an expected current for each pair of wires of the plurality of wires to determine an insulating condition of a circuit partially defined by the pair of wires of the plurality of wires.

11. The method of claim 10, wherein the measured current is a difference between a first current in a first wire of the pair of wires and a second current in the second wire of the pair of wires, and wherein the expected current is zero.

12. The method according to any of the preceding method-based claims, further comprising directly indicating a current leak in the pair of wires without the manipulation of any data in response to a non-zero measured current.

13. The method according to any of the preceding method-based claims, wherein the subsea pressure is between 10 bars and 200 bars.

14. The method according to any of the preceding method-based claims, wherein each non-intrusive current sensor includes a Hall sensor.

15. The method according to any of the preceding method-based claims, further comprising positioning:
a coil of each non-intrusive current sensor to surround a portion of the wire to which the non-intrusive current sensor is coupled, and/or
comparing the difference between the measured current and the expected current for each wire to an allowable current loss for the associated wire to predict a time to failure for each wire; and/or
positioning a plurality of switches with each switch of the plurality of switches coupled to one of the wires of the plurality of wires; and/oropening the switch associated with a wire in response to the difference between the measured current and the expected current exceeding an allowable current loss for the associated wire.
